# EUROPEAN PATENT APPLICATION

(11) **EP 4 637 008 A1**
(43) Date of publication of application: **22.10.2025**
(21) Application number: 25170871.5
(22) Date of filing: 16.04.2025
(51) Int. Cl.: H02M 1/00, H02M 1/10, H02M 1/12, H02M 1/14, H02M 1/44, H02M 7/219, H02M 7/5387, H03H 7/42

(54) **POWER CONVERSION SYSTEM AND VEHICLE**

(30) Priority: 17.04.2024 CN 202410464959
(71) Applicant: Valeo eAutomotive Germany GmbH, 91056 Erlangen (DE)
(72) Inventor: LI, Xufeng, 91056 Erlangen (DE); ZHANG, Minji, 91056 Erlangen (DE); CHEN, Renzhe, 91056 Erlangen (DE); LIU, Tao, 91056 Erlangen (DE); SHI, Shengli, 91056 Erlangen (DE)
(74) Representative: Valeo Powertrain Systems

(57) **Abstract**

A power conversion system and a vehicle are provided. The power conversion system may include: a DC power supply for providing a first DC voltage; an inverter module for converting the first DC voltage into a first AC voltage; a power conversion module for converting the first DC voltage into a second AC voltage, or converting a third AC voltage from outside the power conversion system into a second DC voltage; a first-stage filter circuit connected between a first pair of terminals of the DC power supply and a second pair of terminals of the inverter module, and used for filtering noise signals with frequencies within a first frequency interval and a second frequency interval; and a second-stage filter circuit connected between a third pair of terminals of the first-stage filter circuit and a fourth pair of terminals of the power conversion module, and used for filtering noise signals with frequencies within the second frequency interval, wherein the second frequency interval is different from the first frequency interval.

## Description

### Technical Field

The present application relates to a filtering-related power conversion system and a vehicle.

### Background Art

A power conversion system in a vehicle is an important part for realizing the operation of the vehicle. The power conversion system comprises an inverter module and a power conversion module. The driving process of the inverter module comprises converting DC power (for example, from an on-board energy storage apparatus) into AC power to drive the rotation of a rotating motor, thereby driving the vehicle to operate. On the other hand, the power conversion module, such as an on-board charging circuit (OBC, On Board Charger), may obtain an AC voltage from the outside (for example, a grid voltage may be connected to the on-board charger via a ground AC charging pile or an AC charging port), and convert it into a DC voltage (e.g., a higher voltage, such as 350 V) to charge the energy storage apparatus (such as a battery) in the vehicle, or the DC voltage is further converted into a voltage (e.g., a lower DC voltage, such as 12 V) for supplying power to other components in the vehicle. Alternatively, the DC voltage of the energy storage apparatus inside the vehicle may also be converted into an AC voltage via the power conversion module, so as to supply power to external components that require the AC voltage. That is, the power conversion module may be bidirectional.

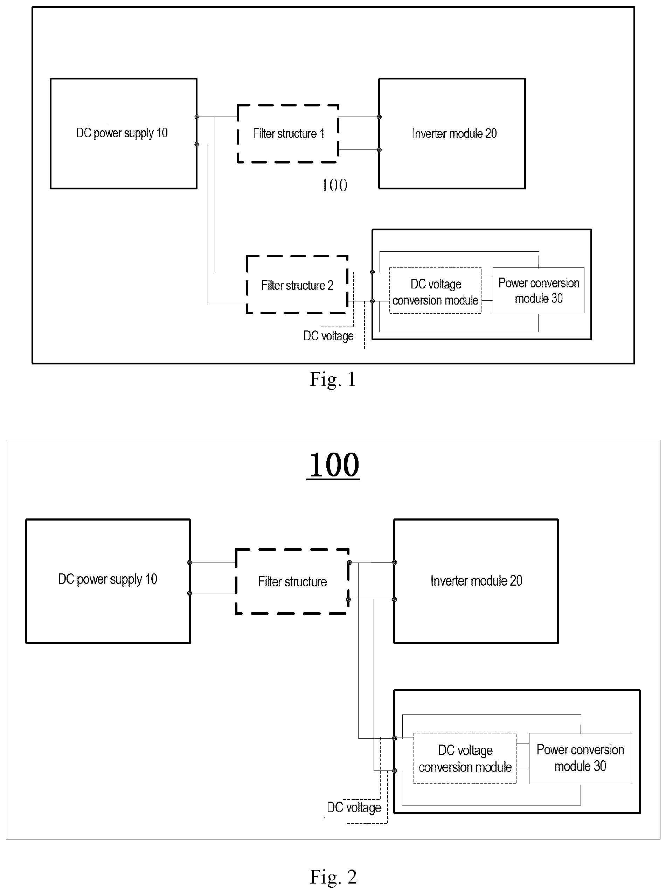

Fig. 1 shows an exemplary structure of a power conversion system in a vehicle. As shown in Fig. 1, the power conversion system 100 may comprise a DC power supply 10, an inverter module 20, and a power conversion module 30. The DC power supply may provide the inverter module with a DC voltage, so that the inverter module converts the DC voltage to generate an AC voltage for driving a rotating motor to rotate. On the other hand, the power conversion module may convert another AC voltage (e.g., an AC voltage from a power grid) input at its input end into a DC voltage to charge the DC power supply (comprising an energy storage apparatus), or the DC voltage is further converted using a DC voltage conversion module comprised in the power conversion system to provide a voltage (e.g., 12V) for supplying power to other components in the vehicle. Alternatively, the DC voltage of the DC power supply 10 may also be converted into an AC voltage via the power conversion module 30.

In addition, both the inverter module and the power conversion module have associated switching devices that are switched at a high frequency. For example, switching devices comprised in inverter bridge arms of the inverter, and switching devices comprised in a rectifier circuit and/or a DC voltage conversion module associated with the power conversion module, may operate in a pulse width modulation (PWM) mode and be switched between an on state and an off state, and thus there may be noise signals caused by switching on vehicle DC links. Therefore, it is often necessary to set additional filter circuits on the vehicle DC links for EMC processing. Usually, as shown by the dotted line in Fig. 1, the DC link corresponding to the inverter module and the DC link corresponding to the power conversion module are each provided with a filter structure to separately filter noise signals in different frequency intervals corresponding to the two circuits.

However, there are the following problems with such independently arranged filter structures: There is no large-capacity X capacitor in the filter structure for the DC link (which may also comprise a DC voltage conversion module) corresponding to the power conversion module (for example, usually considering the noise frequency distribution range, volume and cost), but because the switching frequency associated with the power conversion module may still be 100kHz or so, there is always huge low-frequency noise. Therefore, it is usually difficult to filter out the low-frequency noise to meet customers' requirements. Additionally, the resonance effect always exists between the two filter structures on the two DC links, which will reduce the filtering performance at high frequencies. Therefore, the two situations are both disadvantageous for the electromagnetic compatibility (EMC) performance of the product.

Therefore, there is a need for an improved filter structure, which can filter noise signals in different frequency intervals on the DC links to ensure EMC performance while reducing the costs and volume as much as possible.

### Summary

According to one aspect of the present application, provided is a power conversion system, comprising: a DC power supply for providing a first DC voltage; an inverter module for converting the first DC voltage into a first AC voltage; a power conversion module for converting the first DC voltage into a second AC voltage, or converting a third AC voltage from outside the power conversion system into a second DC voltage; a first-stage filter circuit connected between a first pair of terminals of the DC power supply and a second pair of terminals of the inverter module, and used for filtering noise signals with frequencies within a first frequency interval and a second frequency interval; and a second-stage filter circuit connected between a third pair of terminals of the first-stage filter circuit and a fourth pair of terminals of the power conversion module, and used for filtering noise signals with frequencies within the second frequency interval, wherein the second frequency interval is different from the first frequency interval.

According to an embodiment of the present application, switching of a switching device within the inverter module causes noise signals with frequencies within the first frequency interval and the second frequency interval, and switching of a switching device associated with the power conversion module causes noise signals with frequencies within the first frequency interval and the second frequency interval.

According to an embodiment of the present application, the maximum value of the first frequency interval is less than or equal to the minimum value of the second frequency interval.

According to an embodiment of the present application, the first frequency interval is greater than or equal to 100kHz and less than or equal to 30MHz, and the second frequency interval is greater than or equal to 30MHz.

According to an embodiment of the present application, the first-stage filter circuit and the second-stage filter circuit are anti-electromagnetic interference filter circuits, and each comprise at least one X capacitor, at least one Y capacitor and at least one inductor.

According to an embodiment of the present application, the number of at least one of the X capacitors, Y capacitors or inductors in the second-stage filter circuit is less than the number of the corresponding at least one of the X capacitors, Y capacitors or inductors in the first-stage filter circuit, or a parameter value of at least one of the X capacitors, Y capacitors or inductors in the second-stage filter circuit is smaller than a parameter value of the corresponding at least one of the X capacitors, Y capacitors or inductors in the first-stage filter circuit.

According to an embodiment of the present application, the first-stage filter circuit comprises two common-mode inductors, and the second-stage filter circuit comprises one common-mode inductor.

According to an embodiment of the present application, a first-stage filter circuit comprises a first common-mode inductor, a second common-mode inductor, a first X capacitor, and a second X capacitor, wherein two pins of the first common-mode inductor are connected to the first pair of terminals of the DC power supply, other two pins of the first common-mode inductor are connected to both ends of the first X capacitor, two pins of the second common-mode inductor are connected to both ends of the first X capacitor, other two pins of the second common-mode inductor are connected to both ends of the second X capacitor, and both ends of the second X capacitor are connected to the second pair of terminals of the inverter module; and a second-stage filter circuit comprises a third common-mode inductor, a third X capacitor and a fourth X capacitor, wherein two pins of the third common-mode inductor are connected to both ends of the second X capacitor, other two pins of the third common-mode inductor are connected to both ends of the third X capacitor, the third X capacitor is connected in parallel with the fourth X capacitor, and both ends of the fourth X capacitor are connected to the fourth pair of terminals of the power conversion module.

According to an embodiment of the present application, the power conversion system further comprises a DC voltage conversion module, the DC voltage conversion module being used for converting the second DC voltage into a third DC voltage suitable for supplying power to a component to be powered.

According to an embodiment of the present application, the DC voltage conversion module is integrated with the power conversion module.

According to an embodiment of the present application, the second DC voltage is further used for charging the DC power supply.

According to another aspect of the present disclosure, a vehicle is provided, comprising a power conversion system as described above.

In the power conversion system and vehicle provided in the embodiments of the present application, two filter structures are arranged. One of the two filter structures serves as a common filter structure to filter noise signals in the first frequency interval and the second frequency interval, and the other filter structure is connected to a pair of terminals of the common filter structure, so that the noise signals in the second frequency interval can be further filtered at a position closer to the power conversion module. Therefore, the filtering requirements for noise signals caused by the inverter module and the power conversion module can be met, and this arrangement can also reduce the number or parameter values of filter devices in the filter structure, thereby reducing the costs or volume, etc.

### Brief Description of the Drawings

The drawings illustrate various embodiments of various aspects of the present application, and together with the specification, they are used to explain the principles of the present application. It is understood by those skilled in the art that the specific embodiments shown in the drawings are only exemplary, and they are not intended to limit the scope of the present application. In the drawings:
Fig. 1 shows an exemplary structure of a power conversion system;
Fig. 2 shows an exemplary structure of a power conversion system in which a filter circuit is shared;
Fig. 3 shows an exemplary structure of a power conversion system with a filtering function according to an embodiment of the present application;
Fig. 4 shows an exemplary structure of a first-stage filter circuit and a second-stage filter circuit;
Fig. 5 is a schematic diagram of a vehicle according to an embodiment of the present application.

### Detailed Description of the Embodiments

Technical solutions in embodiments of the present application will be clearly and completely described below in conjunction with the drawings in the embodiments of the present application, and, obviously, the described embodiments are only some, but not all, embodiments of the present application. Any embodiments obtained by those of ordinary skill in the art on the basis of the described embodiments of the present application without making inventive efforts fall within the protection scope of the present application.

As described previously, the independently arranged filter structures in Fig. 1 usually have the problems that it is difficult to filter out low-frequency noise and the resonance effect reduces the filtering performance at high frequencies. Therefore, there is a need for an improved filter structure, which can filter noise signals in different frequency intervals on the DC links to ensure EMC performance while reducing the costs and volume as much as possible.

In the context of the present application, the on-board application scenario is used as an example for explanation. However, it should be understood that the solution of the present application is not limited to the on-board application scenario, but may be applied to other scenarios. For example, the power conversion module (e.g., the on-board charger (OBC) circuit) in the on-board application scenario may be a power conversion module with a bidirectional power conversion function in other application scenarios.

In an embodiment, considering that the inverter module and the power conversion module are usually highly integrated, and that the frequency interval of noise signals caused by the switching of the switching device of the inverter module is substantially the same as the frequency interval of noise signals caused by the switching of the switching device associated with the power conversion module (comprised in the power conversion module itself or comprised in the associated (integrated) DC voltage conversion module), for example, distributed between 100kHz and 245MHz, it can be considered to use only the filter structure for the inverter module, as shown in Fig. 2, which can reduce the costs and volume to a certain extent. However, due to the different arrangement positions of the inverter module and the power conversion module, it is found through testing that the filter structure cannot filter the high-frequency (for example, greater than 30 MHz) noise signals caused by the power conversion module well, so it may affect the EMC performance.

Therefore, the embodiments of the present application provide another improved power conversion system to filter out noise signals caused by the inverter module and the power conversion module.

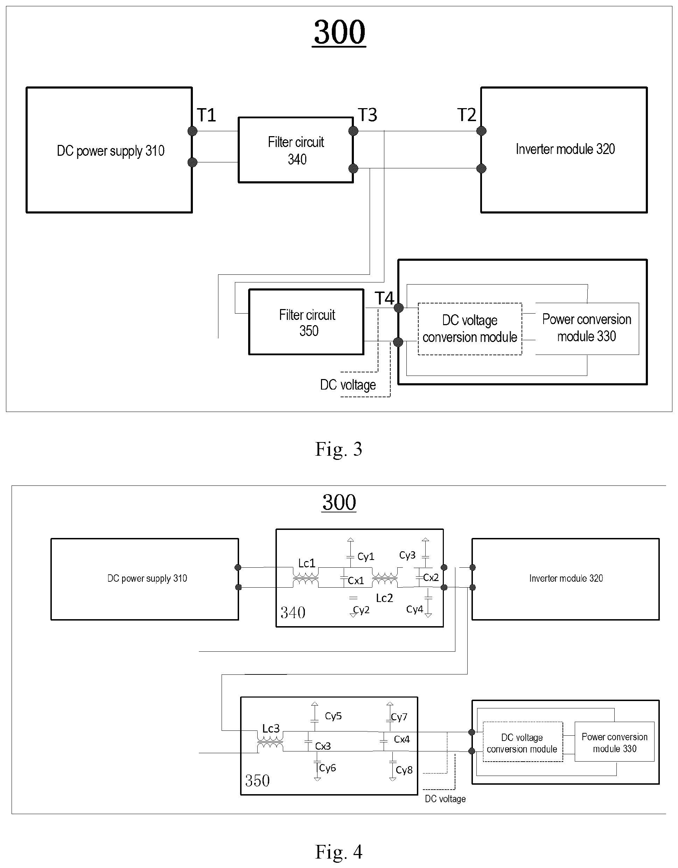

Fig. 3 shows an exemplary structure of a power conversion system with a filtering function according to an embodiment of the present application.

As shown in Fig. 3, the power conversion system 300 comprises a DC power supply 310, an inverter module 320, a power conversion module 330, a first-stage filter circuit 340, and a second-stage filter circuit 350.

The DC power supply 310 may be used to provide a first DC voltage. For example, the DC power supply 310 may be various energy storage apparatuses, such as super capacitors and batteries. The DC power supply 310 may be connected to an on-board DC link through a connector. Optionally, in addition to the energy storage apparatus, the DC power supply may comprise or be associated with other auxiliary circuits, such as a protection circuit or a charge and discharge management circuit, etc., which is not limited in the present application.

The inverter module 320 may be used to convert the first DC voltage from the DC power supply into a first AC voltage. For example, an input end (T2) of the inverter module may receive a DC voltage (the DC voltage may be obtained by filtering the DC voltage outputted by the DC power supply through a first-stage filter circuit described later), and an inversion process is realized through the high-frequency switching of its internal switching device, thereby outputting an AC voltage at an output end. The AC voltage is used as a driving signal of a rotating motor to make the motor rotate. For example, the inverter module may comprise a single-phase or three-phase inverter bridge circuit.

The power conversion module 330 (e.g., an on-board charger) may be used to convert the first DC voltage from the DC power supply 310 into a second AC voltage, or to convert a third AC voltage from outside the power conversion system into a second DC voltage (e.g., a higher DC voltage that may charge the DC power supply). The amplitude of the second AC voltage may be the same as or different from the amplitude of the third AC voltage. Optionally, as an example, the third AC voltage may be an AC voltage from a power grid, and may be used as an input to the power conversion system so as to be converted, through the voltage conversion (e.g., comprising AC to DC conversion and optional DC to AC conversion) of the power conversion module, into a voltage of a suitable level (e.g., a higher level voltage) that can be used to charge the energy storage apparatus in the DC power supply. Optionally, the power conversion module may comprise a full-bridge topology circuit so that AC-DC conversion or DC-AC conversion is performed according to the direction of the input power.

Optionally, the power conversion system 300 may further comprise a DC voltage conversion module, such as a DC-DC conversion module. The DC voltage conversion module is used to further convert the second DC voltage (obtained by converting the third AC voltage input to the power conversion module 330) into a third DC voltage (for example, 12V) suitable for supplying power to a component to be powered, and the DC voltage outputted by the DC voltage conversion module may be filtered by a second-stage filter circuit described later before being provided to the component to be powered. Optionally, the DC voltage conversion module may be integrated with the power conversion module 330. Optionally, the DC voltage conversion module may comprise a step-down circuit, such as a Buck circuit, a fly-back circuit, or other DC-DC circuits.

The first-stage filter circuit 340 may be connected between a first pair of terminals (T1) of the DC power supply 310 and a second pair of terminals (T2) of the inverter module 320, and is used to filter noise signals with frequencies within a first frequency interval and a second frequency interval. The second-stage filter circuit 350 is connected between a third pair of terminals (T3) of the first-stage filter circuit 340 and a fourth pair of terminals (T4) of the power conversion module, and is used to filter noise signals with frequencies within the second frequency interval, wherein the second frequency interval is different from the first frequency interval.

For example, the switching of switching devices in the inverter module and the switching of switching devices associated with the power conversion module (switching devices in the power conversion module and/or the associated DC voltage conversion module) cause noise signals with frequencies in the first frequency interval and the second frequency interval (for example, determined by measurement to be between 100kHz and 245MHz). For example, the maximum value of the first frequency interval may be less than or equal to the minimum value of the second frequency interval. Optionally, according to frequency measurement values of the noise signals caused by the switching devices of the inverter module and the switching devices associated with the power conversion module, the first frequency interval may be greater than or equal to 100kHz and less than or equal to 30 MHz, and the second frequency interval may be greater than or equal to 30 MHz.

That is to say, the first-stage filter circuit is used as a common filter structure, which is used to filter out the noise signals caused by the switching devices of the inverter module and the switching devices associated with the power conversion module in the same frequency interval (for example, a frequency interval greater than or equal to 100kHz and less than or equal to 30MHz and a frequency interval greater than 30MHz (optionally less than or equal to 245MHz)); and the second-stage filter circuit may be regarded as a dedicated filter structure associated with the power conversion module, which can filter out noise signals with high frequencies (for example, greater than or equal to 30MHz) that may still exist near the fourth pair of terminals of the power conversion module after being filtered by the first-stage filter circuit. In this way, the two filter circuits work together. The first-stage filter circuit may maintain its structure when it is only for the filtering process of the inverter module, and the second-stage filter circuit may be better dedicated to filtering a frequency interval with relatively high frequencies (greater than 30 MHz) associated with the power conversion module, so that the number of filter devices or parameter values of some filter devices can be reduced accordingly in the second-stage filter circuit. In addition, the frequency intervals targeted by the two filter circuits are not exactly the same, so the resonance effect between the two filter structures will be correspondingly alleviated, and the EMC performance can thus be improved accordingly.

Therefore, optionally, the first-stage filter circuit 340 and the second-stage filter circuit 350 are anti-electromagnetic interference filter circuits, and each comprise at least one X capacitor, at least one Y capacitor, and at least one inductor. The X capacitor is a capacitor connected across two wires of a DC link, and generally a metal film capacitor may be selected and used. The Y capacitors are capacitors respectively connected across the two wires of the DC link and the ground, and generally appear in pairs. When common-mode interference occurs, the magnetic flux directions of two coils of the common-mode inductor (for example, a common-mode choke) are the same, and the total inductance increases rapidly after coupling, so that a large inductive reactance is presented to a common-mode signal, making it difficult for the common-mode signal to pass through, thereby reducing the common-mode interference.

In some embodiments of the present disclosure, the number of at least one of the X capacitors, Y capacitors, or inductors in the second-stage filter circuit 350 is less than the number of the corresponding at least one of the X capacitors, Y capacitors, or inductors in the first-stage filter circuit 340, or a parameter value of at least one of the X capacitor, Y capacitor, or inductor in the second-stage filter circuit 350 is less than a parameter value of the corresponding at least one of the X capacitor, Y capacitor, or inductor in the first-stage filter circuit 340. For example, the first-stage filter circuit 340 may comprise two common-mode inductors, and the second-stage filter circuit 350 may comprise one common-mode inductor.

Fig. 4 shows an exemplary structure of a first-stage filter circuit and a second-stage filter circuit.

As shown in Fig. 4, the first-stage filter circuit 340 may comprise a first common-mode inductor Lc1, a second common-mode inductor Lc2, a first X capacitor Cx1, and a second X capacitor Cx2. Two pins of the first common-mode inductor Lc1 are connected to the first pair of terminals (T1) of the DC power supply; other two pins of the first common-mode inductor Lc1 are connected to both ends of the first X capacitor Cx1; two pins of the second common-mode inductor Lc2 are connected to both ends of the first X capacitor Cx1; other two pins of the second common-mode inductor Lc2 are connected to both ends of the second X capacitor Cx2; and both ends of the second X capacitor Cx2 are connected to the second pair of terminals (T2) of the inverter module 320.

The second-stage filter circuit comprises a third common-mode inductor Lc3, a third X capacitor Cx3 and a fourth X capacitor Cx4; two pins of the third common-mode inductor are connected to both ends of the second X capacitor Cx2 (that is, the second pair of terminals (T2) of the first-stage filter circuit); other two pins of the third common-mode inductor are connected to both ends of the third X capacitor Cx3; the third X capacitor Cx3 is connected in parallel with the fourth X capacitor Cx4; and both ends of the fourth X capacitor Cx4 are connected to the fourth pair of terminals (T4) of the power conversion module.

In addition, multiple pairs of Y capacitors (Cy1, Cy2, ..., Cy8) are provided in the first-stage filter circuit and the second-stage filter circuit to further improve the EMC performance of the circuits.

Optionally, the first-stage filter circuit may be arranged on a main circuit board of the inverter module, and/or the second-stage filter circuit may be arranged on a main circuit board of the power conversion module.

Therefore, through the structure of the first-stage filter circuit and the second-stage filter circuit shown in Fig. 4, while ensuring the structure of the first-stage filter circuit, the second-stage filter structure can reduce the number (or parameter values (not shown)) of some filter devices accordingly relative to the independently arranged filter circuits as shown in Fig. 1, thereby reducing the costs and volume. Also, compared with the filter structure shown in Fig. 2, the high-frequency noise signals of the power conversion module branch can be better filtered out.

Based on the above description with reference to Figs. 3-4, experimental tests were conducted. During the experiment, on the basis of the fact that the first-stage filter circuit can perfectly filter out noises caused by the switching of switches of the inverter module, the power conversion module (and its associated DC voltage conversion module) was operated at a rated power to test the circuit performance. According to the experimental results, in low-frequency conditions (e.g., for noise signals less than 2 MHz) and high-frequency conditions (e.g., for noise signals less than 30 MHz to 108 Hz), relative to the structures shown in Figs. 1 and 2, these noises can be better filtered out, and as described previously, the requirements for the costs and volume can be reduced.

According to another aspect of the present application, the present application further provides a vehicle. The vehicle may be an electrified vehicle, for example, a battery electric vehicle (BEV), a hybrid electric vehicle (HEV), a plug-in hybrid electric vehicle (PHEV), a range extended EV, or a fuel cell electric vehicle (FCEV). The vehicle may also be a hydrogen-powered vehicle.

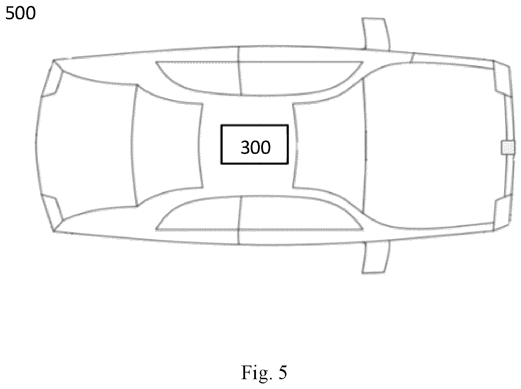

Fig. 5 shows a schematic diagram of a vehicle according to an embodiment of the present application.

As shown in Fig. 5, the vehicle 500 according to the present application comprises: the power conversion system 300 according to the present invention as described above. For the detailed description of the vehicle 500 according to the present application, reference may made to the description of Figs. 3 and 4 in the present application, and it will not be repeated here for the sake of brevity.

Although the present subject matter of various specific exemplary embodiments has been described in detail, each example is provided by way of explaining rather than restricting the present disclosure. After those skilled in the art have gained an understanding of the above-described content, they could easily make changes, variations, and equivalents to such embodiments. Therefore, the present invention does not rule out comprising such modifications, changes and/or additions to the present subject matter which would be obvious to those skilled in the art. For example, some of the illustrated or described features acting as one embodiment can be used with another embodiment to produce a further embodiment. Therefore, the intention is that the present disclosure covers such alterations, changes and equivalents.

Specifically, although the drawings of the present disclosure describe steps performed in a specific order for the purpose of illustration and discussion, respectively, the method of the present disclosure is not limited to the order or arrangement of the specific illustrations. Without departing from the scope of the present disclosure, various steps of the method described above can be omitted, rearranged, combined and/or adjusted in various ways.

Unless otherwise defined, all of the terms (comprising technical and scientific terms) used herein have the same meanings as those commonly understood by those skilled in the art. It should also be understood that terms such as those generally defined in a dictionary should be interpreted as having the same meanings as in the context of the related art, rather than being interpreted in an idealized or extremely formalised sense, unless expressly so defined herein.

The above is a description of the present disclosure and should not be regarded as limiting it. Although several exemplary embodiments of the present disclosure have been described, those skilled in the art will easily understand that many modifications can be made to the exemplary embodiments without departing from the novel teaching and advantages of the present disclosure. Therefore, all such modifications are intended to be comprised in the scope of the present disclosure as defined by the claims. It should be understood that the above is a description of the present disclosure, and should not be deemed to be limited to the specific embodiments disclosed; in addition, modifications made to the disclosed embodiments and other embodiments are intended to be comprised within the scope of the attached claims. The present disclosure is defined by the claims and their equivalents.

## Claims

1. A power conversion system, comprising:
a DC power supply for providing a first DC voltage;
an inverter module for converting the first DC voltage into a first AC voltage;
a power conversion module for converting the first DC voltage into a second AC voltage, or converting a third AC voltage from outside the power conversion system into a second DC voltage;
a first-stage filter circuit connected between a first pair of terminals of the DC power supply and a second pair of terminals of the inverter module, and used for filtering noise signals with frequencies within a first frequency interval and a second frequency interval; and
a second-stage filter circuit connected between a third pair of terminals of the first-stage filter circuit and a fourth pair of terminals of the power conversion module, and used for filtering noise signals with frequencies within the second frequency interval, wherein the second frequency interval is different from the first frequency interval.

2. The power conversion system according to claim 1, wherein switching of a switching device within the inverter module causes noise signals with frequencies within the first frequency interval and the second frequency interval, and switching of a switching device associated with the power conversion module causes noise signals with frequencies within the first frequency interval and the second frequency interval.

3. The power conversion system according to claim 1, wherein
the maximum value of the first frequency interval is less than or equal to the minimum value of the second frequency interval.

4. The power conversion system according to claim 3, wherein the first frequency interval is greater than or equal to 100kHz and less than or equal to 30MHz, and the second frequency interval is greater than or equal to 30MHz.

5. The power conversion system according to claim 1, wherein the first-stage filter circuit and the second-stage filter circuit are anti-electromagnetic interference filter circuits, and each comprise at least one X capacitor, at least one Y capacitor and at least one inductor.

6. The power conversion system according to claim 5, wherein the number of at least one of the X capacitors, the Y capacitors or the inductors in the second-stage filter circuit is less than the number of the corresponding at least one of the X capacitors, the Y capacitors or the inductors in the first-stage filter circuit, or
a parameter value of at least one of the X capacitors, the Y capacitors or the inductors in the second-stage filter circuit is smaller than a parameter value of the corresponding at least one of the X capacitors, the Y capacitors or the inductors in the first-stage filter circuit.

7. The power conversion system according to claim 6, wherein the first-stage filter circuit comprises two common-mode inductors, and the second-stage filter circuit comprises one common-mode inductor.

8. The power conversion system according to any one of claims 5-7, wherein:
the first-stage filter circuit comprises a first common-mode inductor, a second common-mode inductor, a first X capacitor, and a second X capacitor, wherein two pins of the first common-mode inductor are connected to the first pair of terminals of the DC power supply, other two pins of the first common-mode inductor are connected to both ends of the first X capacitor, two pins of the second common-mode inductor are connected to both ends of the first X capacitor, other two pins of the second common-mode inductor are connected to both ends of the second X capacitor, and both ends of the second X capacitor are connected to the second pair of terminals of the inverter module; and
the second-stage filter circuit comprises a third common-mode inductor, a third X capacitor and a fourth X capacitor, wherein two pins of the third common-mode inductor are connected to both ends of the second X capacitor, other two pins of the third common-mode inductor are connected to both ends of the third X capacitor, the third X capacitor is connected in parallel with the fourth X capacitor, and both ends of the fourth X capacitor are connected to the fourth pair of terminals of the power conversion module.

9. The power conversion system according to claim 1, wherein the power conversion system further comprises a DC voltage conversion module, the DC voltage conversion module is used for converting the second DC voltage into a third DC voltage suitable for supplying power to a component to be powered.

10. The power conversion system according to claim 9, wherein the DC voltage conversion module is integrated with the power conversion module.

11. The power conversion system according to claim 1, wherein the second DC voltage is further used for charging the DC power supply.

12. A vehicle, comprising the power conversion system according to any one of claims 1 to 11.
